# EUROPEAN PATENT APPLICATION

(11) **EP 1 204 167 A1**
(43) Date of publication of application: **08.05.2002**
(21) Application number: 01125930.6
(22) Date of filing: 31.10.2001
(51) Int. Cl.: H01R 12/16

(54) **Grid connector**

(30) Priority: 03.11.2000 KR 2000065176
(71) Applicant: GLOTECH INC., KT Venture Center Rm. 403, Seoul (KR)
(72) Inventor: Yoon, Chong Kwang, Pundang-gu, Seongnam-shi, Kyounggi-do (KR); Kim, Young Soo, Gangseo-gu, Seoul (KR)
(74) Representative: Lorenz, Werner, Dr.-Ing.

(57) **Abstract**

A connector for use in electrically connecting two electrical parts includes a plug member and a receptacle for receiving the plug member therein. The plug member has an electrically non-conductive body with a top, a bottom and a side surface and includes a plurality of contact pads formed on the side surface and a number of I/O (Input/Output) contacts disposed on the top surface, the contact pads being electrically connected to one of the electrical part through the I/O contacts. The receptacle has a plurality of contact pins, the contact pads being electrically connected to the other electrical part through their corresponding contact pins.

## Description

The present invention relates to a connector; and, more particularly, to a connector for providing an electrical connection between printed circuit boards (PCBs).

As well known, printed circuit boards (PCBs) having various electronic components thereon in electronic equipments are interconnected by way of board-to-board connectors such as pin-in-socket connectors.

Conventionally, a pin-in-socket connector is made of a set of male terminals and another set of female terminals and two housings for the accommodation thereof.

The male and female terminals are arranged in an elongated configuration and serve only to provide electrical connection between the PCBs and are incapable of rendering any additional electrical functions, e.g., capacitance, inductance and/or resistance. Accordingly, if additional circuit components, e.g., capacitors, inductors and/or resistors are required in order to improve signal interface characteristics between the PCBs, those components are placed on the PCBs, putting an additional burden on the utilization of PCB spacing and routing.

Further, since a minimum pitch between the conductive terminals of the pin-in-socket connectors must be maintained at about 0.5 mm or 0.7 mm in order to prevent a short circuit problem in a solder bridge formation between neighboring conductive terminals, such conventional board-to-board connectors may not be used in the interconnection of heavily integrated and highly functional scaled-down boards of present days.

It is, therefore, a primary object of the present invention to provide a connector for connecting PCBs, which is capable of providing a greater number of terminals per unit mounting area without decreasing a pitch therebetween.

It is another object of the present invention to provide a connector for connecting PCBs capable of preventing signal degradation by incorporating therein and/or thereon circuit components to be used in improving signal interfacing characteristics.

In accordance with the present invention, there is provided a connector for use in electrically connecting two electrical parts, including:
a plug member having an electrically non-conductive body with a top, a bottom and a side surface, the plug member including a plurality of contact pads formed on the side surface and a number of I/O (Input/Output) contacts disposed on the top surface, the contact pads being electrically connected to one of the electrical parts through the I/O contacts; and
a receptacle for receiving the plug member therein, the receptacle having a plurality of contact pins, the contact pads being electrically connected to the other electrical part through their corresponding contact pins.

The above and other objects and features of the present invention will become apparent from the following description of preferred embodiments given in conjunction with the accompanying drawings, in which:
Fig. 1 is a perspective view of an MLG (multiple line grid) connector in accordance with a preferred embodiment of the present invention;
Fig. 2 illustrates a perspective view of an MLG used in the MLG connector shown in Fig. 1;
Fig. 3 describes a perspective view of an MLG receptacle with a plurality of contact pins held in support grooves thereof;
Fig. 4 offers a perspective view of the MLG connector connecting two PCBs;
Fig. 5 represents a cross sectional view of a multilayered MLG;
Fig. 6 shows a cross sectional view of the MLG connector connecting two PCBs, wherein electrical components are provided on the bottom surface of the MLG; and
Fig. 7 depicts a cross sectional view of the MLG connector connecting two PCBs, electrical components being embedded in the MLG.

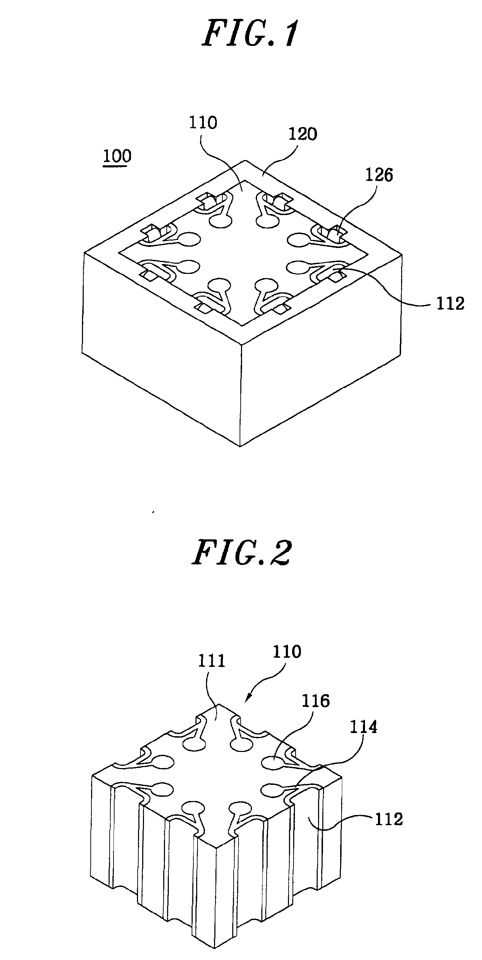

Referring to Fig. 1, there is shown a perspective view of a multiple line grid (MLG) connector in accordance with a preferred embodiment of the present invention. The MLG connector 100 includes an MLG 110 having a plurality of contact pads 112 and an MLG receptacle 120 having a corresponding number of contact pins 126 as the contact pads 112. The MLG 110 is to be combined with the MLG receptacle 120 for the contact pads 112 to be in an electrical contact with the corresponding contact pins 126.

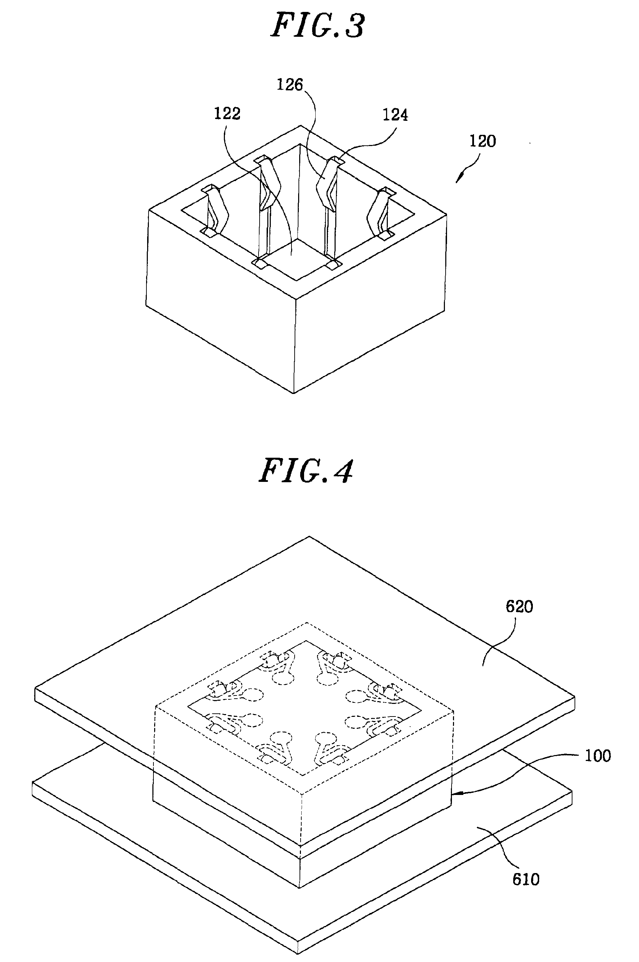

Referring to Fig. 2, there is illustrated a perspective view of the MLG 110 serving as a plug member of the MLG connector 100. The MLG 110 has a grid body 111 made of an insulating material having substantially cuboidal shape. It should be noted that the cross section of the MLG 110 can have any polygonal shape other than the rectangular shown in Fig. 2 when viewed from top. The contact pads 112 are provided on recesses formed on a side surface of the grid body 111. A plurality of I/O (input/output) contacts 116 are disposed on top of the grid body 111 and are electrically connected to their corresponding contact pads 112 through leads 114 provided therebetween. It is preferable that the I/O contacts 116 are distributed across the top surface of the MLG 110 in a manner to maximize the pitches therebetween.

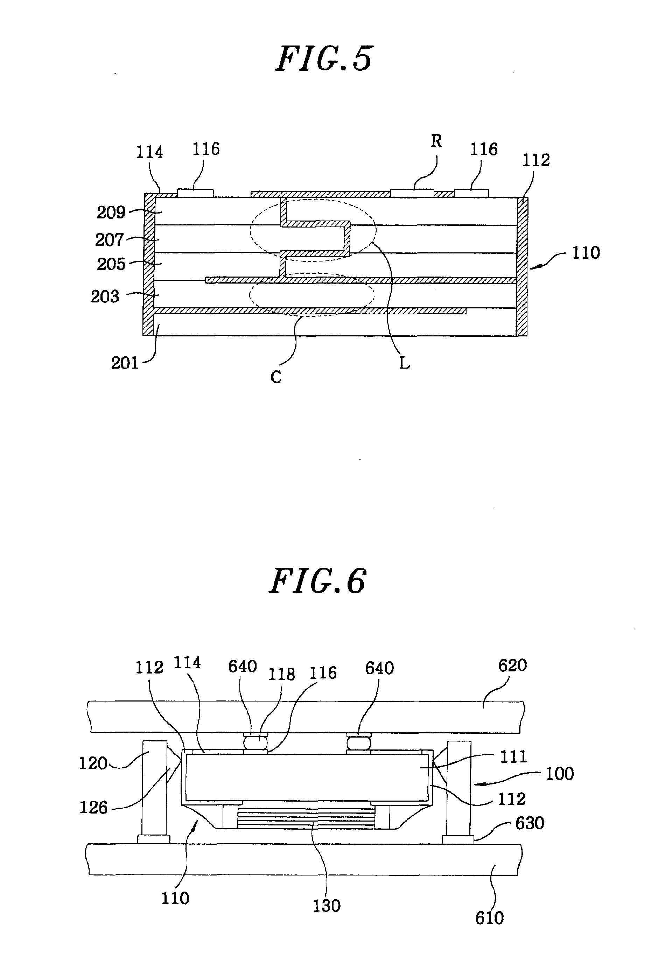

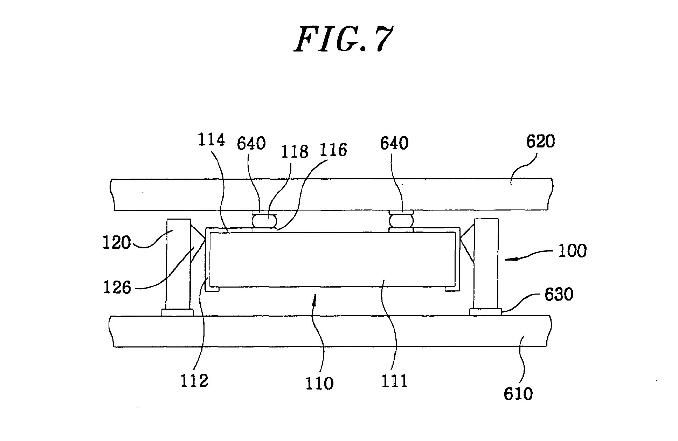

Referring to Fig. 3, there is illustrated a perspective view of the MLG receptacle 120 with the contact pins 126 held in support grooves 124. The MLG receptacle 120 has a substantially box-shaped with a top and a bottom lid thereof removed and is made of an insulating or non-conductive material. Inside the MLG receptacle 120, there is provided an open accommodation space 122 for accepting the MLG 110 therein. On inner side surfaces of the MLG receptacle 120, there are formed the support grooves 124 for holding the contact pins 126. The contact pins 126 are made of a conductive material, e.g., copper or copper alloy, and have a structure capable of exerting resilient force against the contact pads 112 of the MLG 110 in order to provide close contact thereto. When the MLG 110 is combined together with the MLG receptacle 120 as shown in Fig. 1, each contact pin 126 comes into an electrical contact with its corresponding contact pad 112 of the MLG 110. When the MLG connector 100 in accordance with the preferred embodiment of the present invention is used for connecting two PCBs 610, 620 as shown in Fig. 4, lower ends of the contact pins 126 are electrically connected to corresponding connection pads 630 of the lower PCB 610 as shown in Figs. 6 and 7.

The grid body 111 of the MLG 110 can be of a single layered or a bulk structure made of one sheet of insulating material having no electrical components therein. Alternatively, the grid body 111 can be of a multilayered structure as exemplarily shown in Fig. 5, wherein the MLG 110 has a grid body 111 made of, e.g., five layers 201, 203, 205, 207, 209 and electrical components, e. g., a resistor R, an inductor L and/or a capacitor C. The five layers 201 to 209 are made of an insulating material. The electrical components R, L, C are formed by using, e.g., a screen printing method. The electrical components R, L, C can be provided at various locations, e.g., on the top of the grid body 111, between the layers and/or inside via holes of the grid body 111 as shown in Fig. 5. It should be apparent to those skilled in the art that such a multilayered grid body can be readily manufactured by using techniques conventionally employed in producing multilayer ceramic capacitors and inductors.

Referring to Fig. 6, there is shown a cross sectional view of the MLG connector 100 connecting the two PCBs 610, 620. The I/O contacts 116 of the MLG connector 100 are respectively connected to the corresponding I/O pads 640 of the upper PCB 620 through a plurality of solder joints 118, wherein each of the I/O contacts 116 functions as an I/O terminal. The MLG receptacle 120 is attached to the lower PCB 610 and the lower ends of the contact pins 126 are electrically connected to corresponding connection pads 630 of the lower PCB 610. Each of the contact pads 112 is in an electrical contact with the corresponding contact pin 126 and also connected to the corresponding I/O contact 116 through the lead 114. The MLG 110 shown in Fig. 6 can be implemented by using a bulk grid body and includes circuit components 130 attached on the bottom surface thereof, e.g., required to improve a signal interfacing characteristics. The circuit components 130 which can be provided on the grid body 111 can be, but not limited to, one or more resistors, capacitors, inductors, diodes or transistors or a combination thereof.

Referring to Fig. 7, there is illustrated a cross sectional view of the MLG connector 100 having the multilayered grid body 111. The MLG connector 100 shown in Fig. 7 has at least a part of the circuit components 130 shown in Fig. 6. It should be apparent that the grid body 111 shown in Fig. 7 could be a bulk type having no circuit components therein.

As a result, when compared to the conventional pin-in-socket connector including the plurality of male/female conductive terminals arranged in an elongated configuration, the MLG connector 100 in accordance with the preferred embodiment of the present invention has more terminals per unit surface mounting area without decreasing the pitch between the terminals since a plurality of the I/O contacts 116 that function as I/O terminals are disposed in a form of an area array.

Further, it should be noted that the MLG connector 100 of the present invention could be used for connecting an electrical part, e.g., PCB, semiconductor chip, IC package module or cable, having multiple I/O terminals to another electrical part. In such case, the MLG receptacle 120 would be attached on one electrical part and the MLG 110 would be connected to the other electrical part.

It is also to be appreciated that the MLG 110 and the MLG receptacle 120 can be of other shape than the cuboidal shape shown in Fig. 1. For instance, the MLG 110 and the MLG receptacle 120 can be of a cylindrical shape having an oval or a circular cross section when viewed from the top.

While the invention has been shown and described with respect to the preferred embodiment, it will be understood by those skilled in the art that various changes and modifications may be made without departing from the scope of the invention as defined in the following claims.

## Claims

1. A connector for use in electrically connecting two electrical parts, comprising:
a plug member having an electrically non-conductive body with a top, a bottom and a side surface, the plug member including a plurality of contact pads formed on the side surface and a number of I/O (Input/Output) contacts disposed on the top surface, the contact pads being electrically connected to one of the electrical parts through the I/O contacts; and
a receptacle for receiving the plug member therein, the receptacle having a plurality of contact pins, the contact pads being electrically connected to the other electrical part through their corresponding contact pins.

2. The connector of claim 1, wherein the body further has a plurality of recesses formed on the side surface thereof and the contact pads are formed in the corresponding recesses.

3. The connector of claim 1, wherein the body further has a circuit component embedded therein.

4. The connector of claim 3, wherein the circuit component is one of a resistor, an inductor and a capacitor.

5. The connector of claim 3, wherein the body is formed of multiple insulating layers.

6. The connector of claim 1, wherein the body further has a circuit component provided on the bottom surface thereof.

7. The connector of claim 6, wherein the circuit component is one of a resistor, an inductor, a capacitor, a diode and a transistor.

8. The connector of claim 1, wherein the receptacle further has a non-conductive housing encompassing the side surface of the body and wherein the contact pins are provided on an inner surface of the housing.

9. The connector of claim 8, wherein the housing has a plurality of grooves formed on the inner surface thereof, the contact pins being held by the grooves.
